# EUROPEAN PATENT SPECIFICATION

(11) **EP 0 397 102 B1**
(45) Date of publication and mention of the grant of the patent: **17.04.1996**
(21) Application number: 90108641.3
(22) Date of filing: 08.05.1990
(51) Int. Cl.: H02P 7/00, H02H 7/085

(54) **Power delivery circuit with current sensing**
Schaltung zur Leistungsabgabe mit Stromerfassung
Circuit de puissance débitée avec détection de courant

(30) Priority: 09.05.1989 US 349022; 05.07.1989 US 376466
(43) Date of publication of application: 14.11.1990
(60) Divisional application: 95202401.6
(73) Proprietor: UNITED TECHNOLOGIES AUTOMOTIVE, Inc., Dearborn Michigan 48126 (US)
(72) Inventor: Juzswik, David L., Dearborn Heights, MI 48127 (US); Wrenbeck, Bruce R., Dearborn, Michigan 48124 (US)
(74) Representative: Klunker . Schmitt-Nilson . Hirsch

(56) References cited:
- US-A- 4 654 568
- US-A- 4 667 121
- PESC '88 RECORD vol. 2, 11 April 1988, Kyoto JP, pp. 1319-1324; Jeffrey G. MANSMANN et al.: "ASIC like HVIC for interfacing to half-bridge based power circuits"
- ELECTRO/86 AND MINI/MICRO NORTHEAST CONFERENCE RECORD vol. 11, 1986, Los Angeles CA, US, pp. 1-4; Donald L. ZAREMBA Jr.: "How current sense technology improves power MOSFET switching applications"
- ELECTRO/87 AND MINI/MICRO NORTHEAST CONFERENCE RECORD vol. 12, 1987, Los Angeles US, pp. 1-8; Daniel ARTUSI et al.: "New smartpower devices ease the interfacing to power loads"

## Description

The invention relates to a current detection circuit according to the preamble of claim 1.

A current detection circuit of this type is disclosed in ELECTRO/87 MINI/MICRO NORTHEAST CONFERENCE RECORD, Vol. 12, 1987 LOS ANGELES, USA, pages 1-8; D. ARTUSI ET AL.: New smartpower devices ease the interfacing to power loads".

### Technical Field

The invention relates generally to current sensing circuitry and more particularly to current sensing circuitry in combination with a current controlling device in a power delivery circuit, especially of the high-side switch type. The invention even more particularly relates to a current sensing circuit useful for detecting over-current conditions in "H"-bridge-type power delivery circuits for bidirectional motors and in which the current controlling devices are provided by current sensing semiconductors.

### Background Art

The advent of solid state power drivers has created the need to monitor or to sense load current for device protection and other functions. The power delivery circuits for supplying load current to a load and which further include current sensing capabilities are generally known and are of diverse types. In US-A-4,654,568 to Mansmann, there is disclosed an H-bridge switch circuit for a load such as a motor. More specifically, the various switches of the H-bridge are MOSFET semiconductors, with two of those MOSFETs comprising current sensing MOSFETs. In that described embodiment, the current sensing MOSFETs are connected in the "low" side of the power delivery circuit to the motor. The current sensing MOSFETs are multi-cellular devices in which a major current-carrying cellular portion consists of a large number of cells connected in parallel for carrying the main load current and in which a minor current-carrying cellular portion consists of a relatively small number of cells substantially in parallel therewith and having a separate terminal for carrying a current proportional to that load current. That separate terminal is termed the "current sensing" terminal and may be useful for developing a signal indicative of the major current carried by the current sensing MOSFET.

One of the devices interfacing power loads disclosed in the above-mentioned article in ELECTRO/87 is an H-bridge switch circuit similar to that disclosed in said US-A-4,654,568 also having current sensing MOSFETS in the "low" side of the power delivery circuit.

Another H-bridge disclosed in said article uses power MOSFETs in the "high" side and two 'SENSEFETs" in the "low" side. Each of the SENSEFETs consists of four power MOSFETs housed in one package.

In US-A-4,654,568, the current conducted via the current sensing terminal is developed as a voltage level which is applied to an input of an operational amplifier for amplification and subsequent evaluation. The current sensing circuit which converts the current carried at the current sensing terminal to a corresponding voltage level appears in the patent as at least one sensing resistor operatively connected between the current sensing terminal and ground. The operational amplifier is connected to the current sense terminal and amplifies the voltage developed across that resistor (sense voltage). Sensing current in this manner inherently induces errors in the ratioing of the majority current and the sensing current in the current sense MOSFET. More significantly, as the temperature of the current sense MOSFET increases, as under increasing load conditions, the aforementioned induced error percentage and likewise associated sense voltage error percentage increases.

Furthermore, for safety reasons required in automotive applications, power switch protection and current sensing need to be implemented in a "high side" configuration. This configuration places the current switch or power switch in between the positive supply and the load. If the current sensing method demonstrated in US-A-4,654,568 were to be used in a high side configuration, it would have all of the previously described problems. Further, the operational amplifier supply voltage would have to be higher than the sum of the current sense terminal voltage and the amplified voltage drop across the sensing resistor. Since the voltage drops across the current sense MOSFETs (power MOSFETs) are very low, this would require an operational amplifier voltage supply to be higher than the voltage supply connected to the current sense MOSFET, which is typically the battery, V_{BATT}, in automotive applications. This method is further complicated by requiring the threshold reference voltage, which needs to be generated and used for comparing the amplified resistor voltage drop to some threshold for protection, to be operatively referenced above the current sense terminal potential, which is changing with varying load conditions and battery voltage.

One of the embodiments disclosed in the above-mentioned article is a "High Side Switch" being a configuration as set forth in the preceeding paragraph and having problems as explained therein.

Alternatively, an operational amplifier could be connected in a current amplifier configuration, sometimes called a virtual ground reference, instead of a voltage amplifier configuration. This would require the operational amplifier to have a high common mode input voltage nearly equal to the supply voltage, a threshold reference voltage to be operatively referenced below the current sense terminal potential which is changing with varying load conditions and battery voltage, and would require an operational amplifier to work at the high voltage transients that are present in automotive applications (typically filtered to 45 volts).

### Disclosure of the Invention

The invention provides a current detection circuit as defined in claim 1. Preferred embodiments are defined in the dependent claims.

The invention provides a current detection circuit suitable for a power delivery circuit having a switch located on a high potential side of the load and including simple and reliable circuit means to sense a current condition, such as an over-current condition in the load. The power delivery circuit may include means to turn off the current through the switch upon detection of an over-current condition to prevent destruction of the switch or of the load. The foregoing type of circuit is particularly suitable for use with a single-polarity voltage supply, such as typically provided in automobiles.

The invention provides simple and reliable circuit means to sense the condition of current through a current switch to a load which functions accurately within a relatively narrow tolerance range and over a relatively broad operating range.

Further, the invention provides a power delivery circuit with over-current protection that functions accurately and reliably despite large changes in ambient temperature, such as is typically encountered in an automobile.

The invention can be used in a power delivery circuit with over-current protection that can be inexpensively manufactured with the use of readily-available discrete components.

Moreover the invention provides an improved current detection circuit for use in conjunction with a current controlling device such as a current sensing MOSFET, connected to respective ones of two auxiliary terminals associated with the current sensing MOSFET. Further, the invention provides a current detection circuit having a constant load current (I_{L})-to-voltage sense (V_{S}) conversion ratio which is independent of variations in the supply potential and in the load current.

Further, the invention provides a current detection circuit of the type described which is particularly suited for use with a current sensing device or switch in a "high side" configuration and which exhibits improved accuracy.

Such improvements in accuracy and stability are obtained with a concomitant minimization of cost and complexity associated with the number of resistors required.

In accordance with a preferred embodiment of the invention, the power delivery circuit for supplying load current to a load is provided. The circuit includes a power node for connection to a source of electrical power, a load node for connection to a load, and a high potential current path for supplying electrical current from the power node to the load node. The high potential current path includes a current switch whose switching state is controlled by a control signal on an associated control terminal. The power delivery circuit further includes current sensing circuitry for reliably sensing the level of load current over a wide operating range. The power delivery circuit may further include a single, highly reliable over-current detection circuit responsive to the sensed condition of current in the high potential current path. The over-current detection circuit is for detecting when the current in the high potential current path exceeds a predetermined level. The power delivery circuit, preferably, further includes current turn-off means for disabling current flow to the load when an over-current condition is detected.

In a preferred embodiment of the invention for providing accurate and reliable over-current detection, the current switch in the high potential current path comprises a multicellular device with a plurality of terminals including a first main current terminal connected to the power means, a second main current terminal connecting a majority of device cells to the electrical load, a first auxiliary terminal connected at one end to a minority of device cells so as to provide a current generally proportional to the main device current, and a second auxiliary terminal connected at one end to the majority of device cells. The over-current detection circuit in this embodiment preferably comprises one branch connected between the first auxiliary terminal and a reference potential such as ground and including, in serial circuit, a bias-controlled transimpedance device such as a transistor and a resistor placed between the trans impedance device and the ground and providing a voltage at one end approximately proportional to the main device current, and another branch connected between the second auxiliary terminal and the ground and providing a control signal for the transimpedance device in the first branch.

The transimpedance device in the foregoing over-current detection circuit beneficially couples the current from the high-potential-side first auxiliary node to the resistor that is at low potential. This permits such resistor to be selected so as to provide a desired sense voltage indicative of a particular load current. Moreover, the branch connected between the second auxiliary terminal and the ground for providing the control signal preferably includes a transistor having its base cross-connected to the trans impedance device in the first branch and further having its base shorted to its collector.

A further improved current detection circuit is provided which has particular utility in power delivery circuits in which the current controlling device is in the "high side", and especially in the high side of an H-bridge switch arrangement. The further improved current detection circuit includes first and second branches each connected at one end to a respective one of the first and second auxiliary terminals and includes means for connection in common at the other end to a reference potential in the power delivery circuit. More specifically, the current detection circuit comprises the first branch including first and third series-connected semiconductor devices, such as transistors; the second branch including second and fourth series-connected semiconductor devices, such as transistors; the first and fourth semiconductor devices each being controlled by bias signals and acting in a transimpedance mode of operation; the second and third semiconductor devices being cross-connected with the first and fourth semiconductor devices respectively to provide the respective bias signals thereto; and the first branch further including impedance means, such as a resistor, connected in series circuit therewith for providing a voltage at a node at one end of the impedance means approximately proportional to the main device current, that node being connectable to a detection circuit.

In accordance with an embodiment of the invention, the first, second, third and fourth semiconductor devices comprise respective bipolar transistors, and the first and second transistors are of one conductivity type and the third and fourth transistors are of the opposite conductivity type. Further, the first main current terminal of the current controlling device is adapted to be connected to one polarity of a source of power having relatively opposite polarities, the second main current terminal of the current controlling device is adapted to be connected to one side of a load, and the other side of the load is adapted to be connected to the other polarity of the source of power. The current controlling device with the current sensing capability is preferably connected in the "high side" of the power delivery circuit such that it is relatively more positive than the load. Both the first and the second transistors are PNP transistors and the third and fourth transistors are NPN transistors. The reference potential in the power delivery circuit, to which the first and second branches of the sensing circuit are adapted to be connected in common, is the other polarity of the source of power, and is typically ground.

The betas (β) of the first and second transistors are substantially identical and the betas of the third and fourth transistors are substantially identical.

Further in accordance with an embodiment of the invention, the second and third transistors are each connected in respective shorted base-to-collector configurations and the base of the second transistor is connected to the base of the first transistor and the base of the third transistor is connected to the base of the fourth transistor. The impedance means in the first branch is a first resistor. In one embodiment, the second branch circuit includes a respective second resistor in series circuit therewith. In an alternate embodiment, a single resistor is connected in common in the first and the second branches and is connected to the reference potential.

In a further embodiment, still further improvement in performance of the current detection circuit may be realized through the addition of fifth and sixth transistors thereto as an alternative to or modification of the shorted base-to-collector connections. The circuit becomes less sensitive to beta variations, and thus temperature, in the other four transistors.

In a still further embodiment, fifth and sixth transistors are added to the current detection circuit, a respective one being serially connected in each of the branches intermediate the other transistors. The respective fifth and sixth transistors provide the major voltage drops thereacross to minimize the voltage across the other transistors and thereby minimize variations in the betas of those other four transistors despite variations in the supply voltage.

### Brief Description of the Drawings

Fig. 1 is a schematic illustration partially in block diagram form providing an overview of the present invention as used in a so-called "H"-bridge circuit.
Fig. 2A is a schematic circuit diagram partially in block form of current switch S₁ and over-current detector 24 of Fig. 1.
Fig. 2B is a schematic illustration of an alternative current-sensing circuit that can be used in the over-current detector of Fig. 2A.
Fig. 3 is a simplified schematic of a multicellular current switch preferably used to implement switch S₁ in Fig. 1.
Fig. 4 is a block diagram of sub-circuits contained within gate override circuit 26 of Fig. 1.
Fig. 5 is a schematic illustration partially in block form of a generalized form of an embodiment of the invention.
Fig. 6 is a schematic circuit diagram of another embodiment of the invention.
Fig. 7 is a schematic illustration partially in block diagram form providing a generalized view of another embodiment of the current sensing circuit of the invention, connected in operative association with current controlling devices, such as current sensing switches, in an H-bridge switch arrangement.
Fig. 8 is a schematic circuit diagram depicting, in detail, one embodiment of the current sensing circuit of Fig. 7.
Fig. 9 is a schematic circuit diagram of a second embodiment of the type of current sensing circuit of Fig. 7.
Fig. 10 is a schematic circuit diagram of a third embodiment of the type of current sensing circuit of Fig. 7.
Fig. 11 is a schematic circuit diagram of a fourth embodiment of the type of current sensing circuit of Fig. 7.
Fig. 12 is a schematic circuit diagram of a in fifth embodiment of the type of current sensing circuit of Fig. 7

### Best Modes For Carrying Out The Invention

In the drawings, like reference numerals refer to like parts unless otherwise noted.

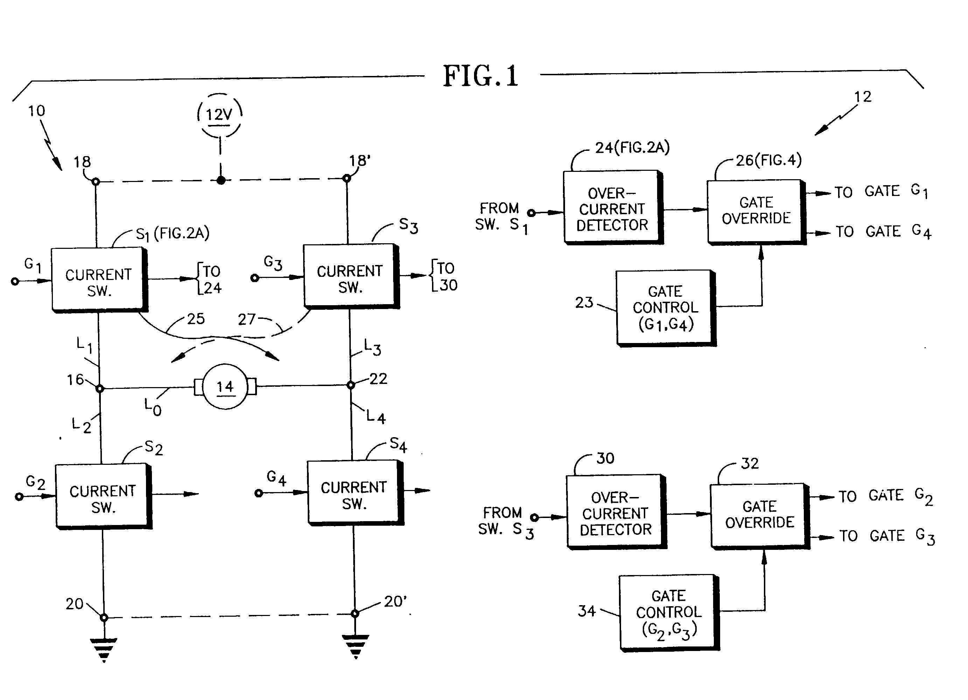

Fig. 1 shows a general overview of the power delivery circuit, and the current detection circuit of the invention as used in conjunction with an exemplary H-bridge circuit 10. The power delivery circuit of Fig. 1 additionally includes control circuitry 12 associated with H-bridge circuit 10.

Considering first H-bridge circuit 10, a load leg L₀ extends horizontally and contains a load 14, such as an electrical motor. Vertical leg L₁ extends between left end node 16 of load leg L₀ and an upper node 18, which typically is at a nominal 12-volt potential for automotive applications. Load leg L₂ extends between node 16 and a node 20, typically at ground reference potential. Connected between a right end node 22 of load leg L₀ and an upper node 18′ is load leg L₃. Load leg L₄ is connected between end node 22 and ground node 20′.

The reference to "vertical" and "horizontal" orientations of the various legs of H-bridge circuit 10 are, of course, merely for descriptive purposes and may or may not accurately describe the layout of an actual H-bridge circuit.

As indicated by the phantom lines high potential nodes 18 and 18′ are typically interconnected, and ground nodes 20 and 20′ similarly are also interconnected.

Contained within load legs L₁ to L₄, respectively, are current switches S₁ to S₄, respectively. These switches are controlled by respective signals on their gates G₁ to G₄. As used herein, the term "gate" broadly encompasses any form of control lead for changing the switching state of a current switch. As such, the term "gate" is intended to be synonymous with the "base" of a bipolar transistor, for example.

In order to direct current through load 14 in the direction shown by a curved arrow 25, appropriate signals are placed on gates G₁ and G₄ of switches S₁ and S₄, respectively, to turn such switches on, while appropriate signals are placed on the gates G₂ and G₃ of switches S₂ and S₃, respectively, to keep these switches off during this time. Conversely, to direct current through load 14 in the direction shown by curved arrow 27, switches S₂ and S₃ are made to conduct by appropriate control of their gates, while the other switches S₁ and S₄ are kept off during this time.

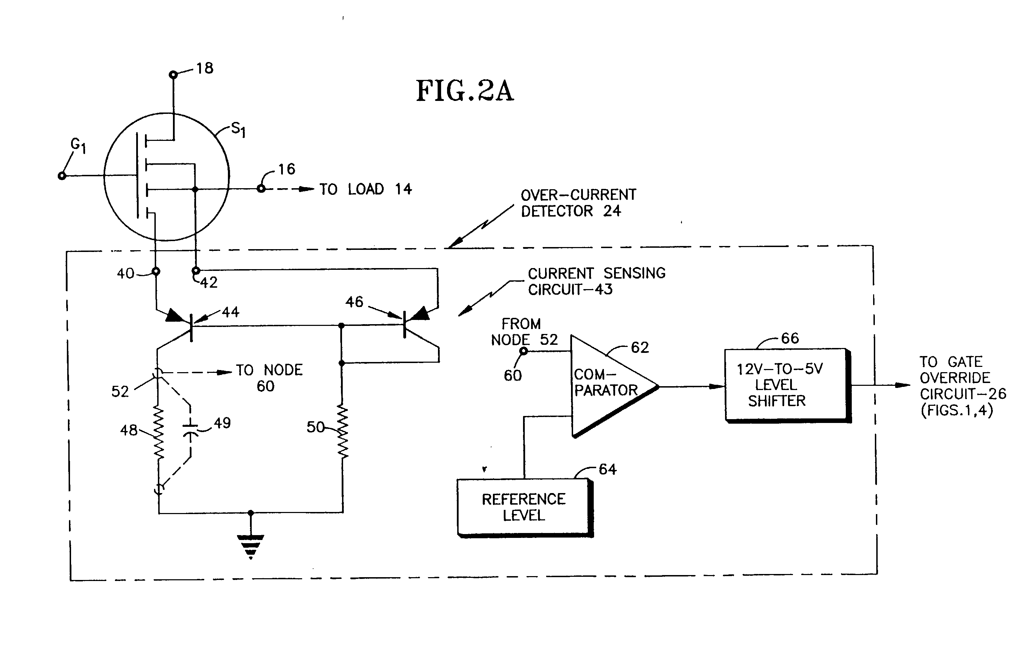

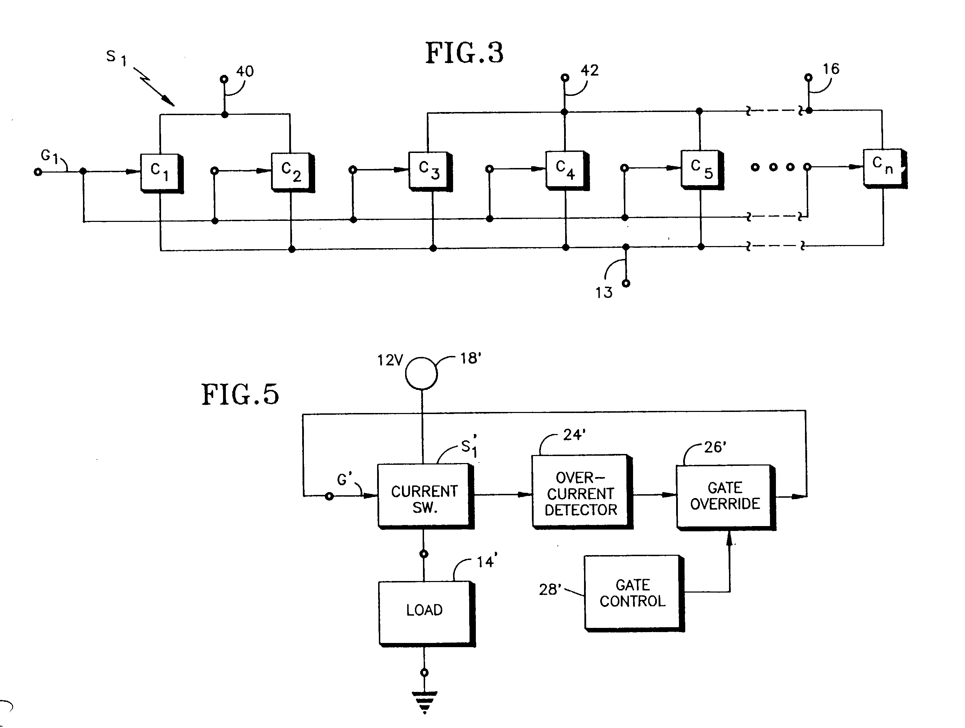

In order to prevent an over-current condition from destroying the load 14 or the switches S₁ and S₃ located in the high potential legs of H-bridge circuit 10 ("high side switches"), over-current detectors 24 and 30, shown as part of control circuity 12, respond to electrical conditions in high potential legs L₁ and L₃, respectively. In a preferred arrangement, over-current detector 24 is responsive to electrical conditions within switch S₁, described below in connection with Figs. 2A and 3.

Continuing with Fig. 1, if an over-current condition is detected by detector 24, a gate override circuit 26 overrides a conventional gate control function 23 to assure that switches S₁ and S₄ remain off. Similarly, upon detection of an over-current condition in switch S₃ by detector 30, a gate override circuit 32 prevents conventional gate control function 34 from turning on switches S₂ and S₃.

Switch S₁ and over-current detector 24 are described in greater detail in Fig. 2A. Switch S₃ and over-current detector 30 are suitably of corresponding construction to switch S₁ and detector 24. Turning to Fig. 2A, switch S₁ is represented by a symbol for a MOSFET device, such as that sold by International Rectifier under the trademark "HEXSense". The main load terminals of HEXSense device S₁ are illustrated as terminals 16 and 18. Terminal 16 is the main source terminal of switch S₁, and terminal 18 is the sole drain terminal of the switch. Gate G₁ corresponds to gate G₁ of current switch S₁ of Fig. 1.

HEXSense device S₁ includes two auxiliary, further terminals 40 and 42. The interrelation of auxiliary terminals 40 and 42 to the main terminals 16 and 18 of switch S₁ is explained in connection with the schematic representation of switch S₁ in Fig. 3. Cells C₁ through Cₙ shown in Fig. 3, represent individual cells of HEXSense device S₁. Common gate G₁ provides a common gate signal for the individual gates of cells C₁-Cₙ. Drain electrode 18 serves as a common drain electrode for all the cells C₁-Cₙ. Source terminal 16 serves as a common source for a majority of the cells of switch S₁, namely cells C₃-Cₙ, while terminal 42 (generally referred to as the Kelvin terminal, K) serves as an auxiliary source electrode connected in common with source electrode 16 except for minor metalization resistance (not shown). Auxiliary terminal 40 (sometimes designated "C.S." for current sensing electrode) serves as a source electrode for only a minority of the cells of switch S₁, namely cells C₁-C₂. In an actual device having several thousands or more cells, the auxiliary terminal 40 could serve as a source for perhaps several hundreds of cells.

HEXSense device S₁ is formed as one integrated circuit with each of its cells having similar characteristics to its other cells. For this reasons, a current which flows from drain 18 to auxiliary source 40 is approximately proportional to the current that flows from drain 18 to main source 16, where such proportion is determined by the ratio of the minority number of cells connected to terminal 49 to the majority number of cells connected to terminal 16.

Further details of HEXSense device S₁ are contained in Power MOSFET Application Notes, No. AN-959, published by International Rectifier in 1986, and incorporated herein by reference.

In view of the above description of the multicellular construction, it will be apparent to those skilled in the art that other types of multicellular switching devices could be used herein instead of a HEXSense device. By way of example, a multicellular thyristor device would comprise a suitable replacement.

Returning to Fig. 2A, auxiliary terminals 40 and 42 are shown connected to a current-sensing circuit 43 having two branches and comprising PNP bipolar transistors 44 and 46 and resistors 48 and 50. Current from S₁ that flows through auxiliary terminal 40 is conducted in one branch through a bias-signal controlled transistor 44 to cause a voltage drop across resistor 48. Transistor 44 and resistor 48 are series connected in the one branch, with the transistor connected to auxiliary terminal 40 and the resistor having one end connected to ground in the illustrated embodiment. Neglecting the bias signal, or base current, in transistor 44, the voltage drop across resistor 48 is proportional to the current flowing through terminal 40 and, hence, to the load current flowing through terminal 16. The voltage at node 52 is thus proportional to the load current. Transistor 44 functions as a transimpedance device to couple the current from the high potential side auxiliary node 40 to the low potential side resistor 48. This permits resistor 48 to be selected so as to provide a desired sense voltage indicative of a particular load current.

In the other branch, transistor 46 of circuit 43, having a short across its base and collector so as to function as a P-N diode, provides a bias signal (base current here) for transistor 44. Transistor 46 and resistor 50 are series connected in that other branch, with the transistor connected to auxiliary terminal 42 and the resistor connected between the transistor's collector and ground.

For optimized performance, it is preferred that the transistors 44 and 46 be formed of matched silicon and that the base currents of those transistors be substantially the same. In this manner, the voltage drops across the emitter-base junctions of transistors 44 and 46 are nearly equal. Thus, the sensing circuit 43 forms an impedance matching buffer and will maintain the same voltage at terminal 40 as the voltage at terminal 42. It should be appreciated that this is a critical requirement to maintain the current ratio accuracy of the HEXSense device. Small deviations in the voltage between terminals 40 and 42 create large errors in the current ratio of the HEXSense device.

Resistors 48 and 50 of the current-sensing circuit 43 are preferably, but not necessarily, selected to result in equal currents through them when an over-current condition occurs in the load. Resistors 48 and 50 may be selected so that the voltage at node 52 varies somewhat linearly with the load current about a particular value of load current according to the ratio of the number of cells in HEXSense switch S₁ connected to auxiliary terminal 40 to the number of cells in such switch connected to load 14. A circuit designer can, however, select resistors 48 and 50 so that the voltage at node 52 varies as above with load current but according to a ratio differing from the foregoing ratio. Thus, a circuit designer can select resistors 48 and 50 to alter the relative change of voltage at node 52 to the change of level of current in load 14.

Where the line voltage on node 18 (Fig. 2A) is nominally 12 volts, PNP transistor 44 and 46 typically each have a beta value of 200 and a breakdown voltage of 60 volts, and resistors 48 and 50 typically have values of 487 and 9.1K ohms, respectively. Additionally, a 0.001 or 0.01 microfarad capacitor 49 (shown in phantom) is preferably placed across resistor 48 to filter any potential current spikes during turn-on.

The above-described arrangement of current-sensing circuit 43 is relatively accurate and stable, being well-suited to provide a voltage at node 52 which is proportional, within a tolerance of about ±3%, to the actual current through the associated current switch (and load) in the region of a particular value of load current across a relatively broad range of operating characteristics, as often encountered in, for example, an automotive environment. That operating range across which this circuit configuration is accurate to within ±3% includes variations of ±25% in the supply potential from the nominal 12 volts, variations in the gains (β) of transistors 44 and 46 in the range of 100 to 500, or more and/or variations in temperature of ±60°C from an ambient of about 25°C. Such variations in the supply potential are occasioned by inductive loading on the battery supply and/or dissipation via age and/or loading. Variations in the transistor gains (β) occur through initial mismatch and particularly as operating temperatures change, with lower gains (i.e., 100 or less) being at relatively cold ambient temperatures and the higher gains (i.e., 500 or more) being at hot operating temperatures.

The voltage on node 52 of current-sensing circuit 43 may serve as an input to a variety of "use" devices, and in the described embodiment it is applied to input node 60 of a comparator 62, whose other input is a reference voltage level 64 selected to determine the over-current level. The output of comparator 62 is then processed by a 12-volt-to-5-volt level shifter 66 so that further processing can conveniently occur with standard 5-volt logic circuitry. When the voltage at node 60 exceeds that of reference level voltage 64, the comparator 62 provides an output, processed by voltage level shifter 66, which is applied to gate override circuit 26 described in connection with Figs. 1 and 4.

Current-sensing circuit 43 can be replaced by one of the other circuits described below that provide a voltage at node 60 of comparator 62 that is approximately proportional to load current, with possibly greater or lesser accuracy and greater or lesser cost.

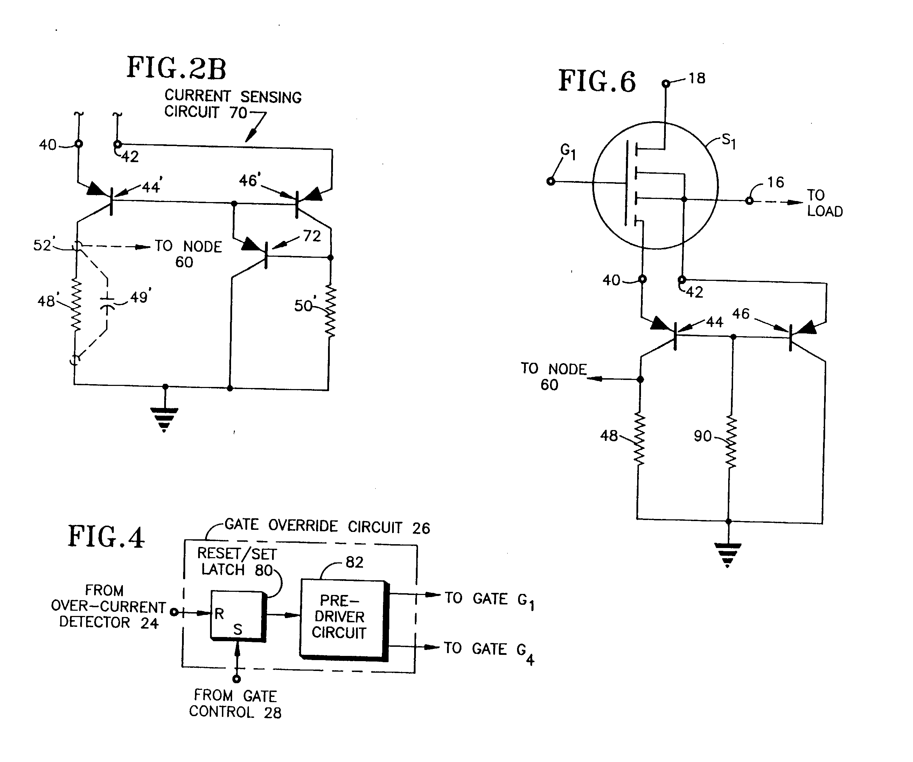

An alternative current-sensing circuit is illustrated in Fig. 2B as circuit 70. Like circuit 43 of Fig. 2A, circuit 70 of Fig. 2B preferably includes two PNP bipolar transistors 44′ and 46′ and resistors 48′ and 50′. Transistor 44′ and resistor 48′ of circuit 70 function in the same manner as the like-numbered elements of circuit 43 of Fig. 2A. An additional PNP bipolar transistor 72, however, is provided in association with transistor 46′. The addition of transistor 72 provides a measure of gain stabilization which causes circuit 70 to operate slightly more consistently for variations in ambient temperature and supply voltage.

With the possible exception of matched-silicon transistors 44 and 46, both current-sensing circuits 43 and 70 (Fig. 2A and 2B) may be advantageously formed by inexpensive, discrete elements.

In current-sensing circuit 70, PNP transistors 44′, 46′ and 72 preferably each have a typical beta value of 200 and a typical breakdown voltage of 60 volts, and resistors 48′ and 50′ preferably have values of 240 and 6.5K ohms, respectively. Additionally, a shunting capacitor 49′ (shown in phantom) across resistor 48′ is preferably used to filter any potential current spikes during turn-on. Typical values are 0.001 or 0.01 microfarads.

In Fig. 4, gate override circuit 26, described above in connection with Fig. 1, is shown in more detail. Considering Fig. 4, an over-current signal from over-current detector 24, typically at a 5-volt level, may be provided to the reset terminal of a reset/set latch 80, which may be conventionally formed by two CMOS NAND gates (not shown). A signal applied to the reset terminal of latch 80 will override any signal from gate control function 28 which is supplied to the set input of the reset/set latch 80 and which typically is a 5-volt signal from a microprocessor. The output of the reset/set latch 80 is then processed by a pre-driver circuit 82 to provide appropriate biasing signals for gates G₁ and G₄ of switches S₁ and S₄ (Fig. 1), respectively.

The high potential side gates G₁ and G₃ are preferably provided with a biasing voltage of about 12 volts above the supply voltage, which may be generated with a conventional voltage-doubling circuit (not shown). This is in contrast to the low potential side gates G₂ and G₄ which are preferably provided with a biasing voltage at the supply voltage level, typically 12 volts. Pre-driver circuit 82 cooperates with a counterpart pre-driver circuit (not shown) of gate override circuit 32 (Fig. 1) to provide the foregoing biasing voltages. The foregoing pre-driver circuits can be designed as illustrated to have one logic input from latch 80 control switches S₂ and S₃ and the other logic input (not shown) control the other two switches. Alternatively, the pre-driver circuits can be designed to have one logic input toggle switches S₁, S₂, or vice-versa; and to have the other logic input likewise toggle the other switches.

Pre-driver circuit 82 and its counterpart (not shown) for switches S₂ and S₃ can, further, be designed to provide delay times to the control signals on gates G₁-G₄ to insure that current is fully off in one direction through the load before causing current flow in the other direction. Alternatively, gate control functions 28 and 34 (Fig. 1), typically implemented by a microprocessor, may provide such delay times.

Fig. 5 shows a more generalized form of an embodiment of the invention in which a single current switch S₁′ is placed on the high potential side of a load 14′. The over-current detector 24′, gate override circuit 26′, and gate control function 28′ correspond to the like-numbered parts shown in connection with the above-described power delivery circuit of the H-bridge type.

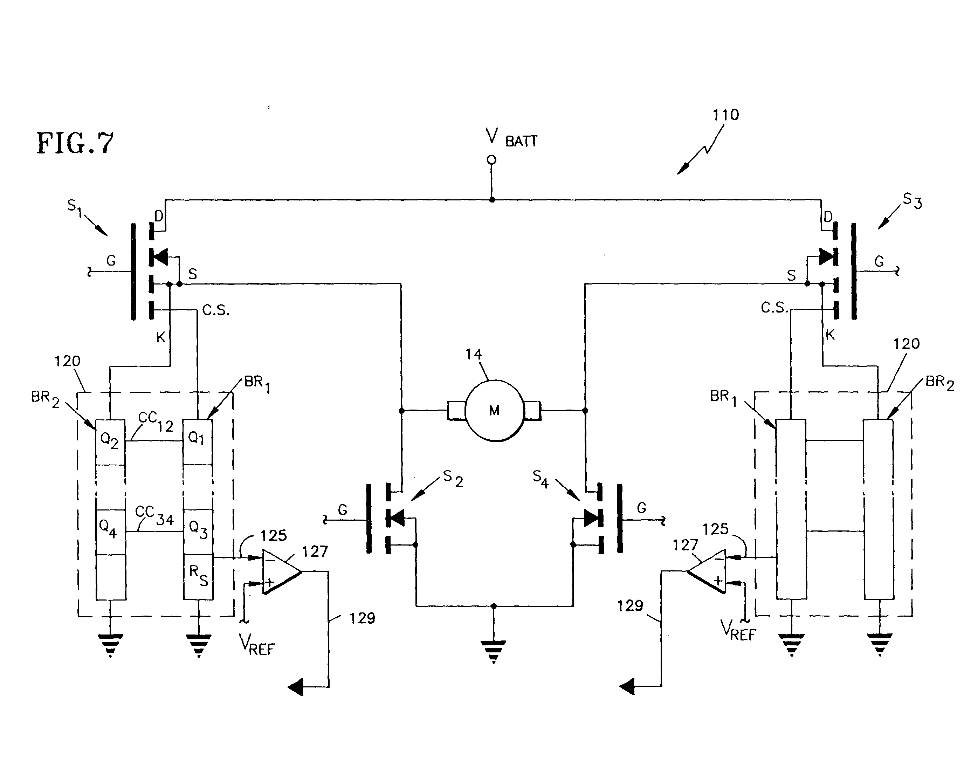

Fig. 6 shows still another embodiment of a current-sensing circuit in which all components similar to those of Fig. 2A have like identifying numerals. Fig. 6 differs from Fig. 2A in that resistor 90 is tied between the bases of transistors 44 and 46 and ground and the collector of transistor 46 goes directly to ground. The circuit of Fig. 6 has been found to experience significant variations in current ratio with changes in voltage, current, transistor beta mismatch, and temperature change. These problems are largely avoided in the circuit of Fig. 2A, particularly in response to changes in supply voltage, beta mismatch and temperature changes. The circuit of Fig. 6 demonstrates, in some respects, the principle of operation of the circuits of Figs. 2A and 2B. Although it may be satisfactory for some applications having constant operating conditions or in which significant accuracy is not required, it is not generally suited to typical automotive applications requiring an accuracy within ±3% across the earlier-mentioned operating ranges. In the circuit of Fig. 6, resistor 48 may have a resistance of 1000 ohms and resistor 90 a resistance from 100K to 1 megohm.

Although the current sensing circuits which employ a plurality of matched transistors in an inverted current mirror configuration do provide certain advantages over the current sensing circuitry associated with the aforementioned U.S. patent 4,654,568, they still exhibit certain limitations when the supply voltage in the power delivery circuit varies, such that they maintain a constant current proportionality between the sense current and the load current over only a limited load current range. These limitations manifest themselves as errors in the current sensing MOSFET(s) ratio or proportionality and in the sensing circuits connected thereto. However, the circuitry of Figs. 7-12 overcomes most of those limitations.

Referring now to Figs. 7-12 depicting a further improvement of the present invention wherein like reference numerals refer to like parts.

Fig. 7 depicts the current sensing circuit of the invention in a generalized block diagram form and connected in operative association with one or more current controlling devices, and specifically current sensing switches, which are in turn connected in a power delivery circuit to a load. More particularly, the current sensing switches are part of an H-bridge switching arrangement for providing bidirectional control of the load device. More particularly still, and of significant importance to the invention, each current sensing switch to which the current sensing circuitry of the invention is connected appears in the "high", or relatively more positive, side of the power delivery circuit relative to the load device.

In Fig. 7, an H-bridge circuit 110 includes a load 14, such as a bidirectional electrical motor. The upper, or "high" side, arms of the H-bridge circuit 110 is connected to a relatively positive power supply potential, in this instance V_{BATT} which may correspond with the battery supply voltage in a vehicle. The lower, or "low" side, arms of the H-bridge circuit 110 are connected to the opposite polarity of the power supply, which in this instance is connected to ground potential. Ground potential serves as the reference potential for the power supply circuit.

Connected in the upper left and upper right arms of the H-bridge 110 are current controlling devices having a current sensing capability and specifically, current-sensing power switches S₁ and S₃, respectively. The current sensing switches S₁ and S₃ represent the type of power carrying field effect transistor which is multi-cellular, and includes a major current carrying cellular portion and a minor current carrying cellular portion as previously described. The current sensing MOSFETs S₁ and S₃ include a gate terminal G for control, major current-carrying terminals represented by the drain D and by the source S, a first auxiliary terminal, C. S., connected at one end to the minority of cells in the sensing MOSFET S₁ so as to provide a current generally proportional to the main device current, and a second auxiliary terminal, generally designated the Kelvin terminal, K, connected at one end to the majority of the cells of switch S₁ and substantially electrically in common with the source terminal.

Typically, the direction of rotation of motor 14 will be controlled by causing current flow therethrough in one direction or the other. Thus, for example, current sensing switch S₁ in the upper left leg and switch S₄ in the lower right leg will be caused to conduct concurrently for motor rotation in one direction. In such instance, current from the source V_{BATT} will flow via the drain terminal D of current sensing switch S₁, and includes the major component of current supplied to the other polarity (i.e., ground potential) of the power supply via the power switch S₄ and the motor 14 from the source terminal S and the majority of cells in the current sensing switch S₁. A current proportional to but less than, the main current at terminal S is in turn provided via the minority cells at the current sense terminal C.S. Typically, the ratio of cells or major current carrying cellular portion to minor current carrying cellular portion, and thus of currents, may be on the order of 1000:1.

To provide a signal which is proportional to the main current carried by the source terminal S, it is necessary, or at least highly preferable, that the potential at the C.S. terminal be the same as that at the source terminal S. Accordingly, an auxiliary contact designated the Kelvin contact K is electrically connected to the source terminal S and provides a signal representative of the potential at the source terminal. As will be hereinafter appreciated, the current sensing circuit associated with current sensing MOSFET S₁ endeavors to maintain the potential at the Kelvin terminal K and the current sense terminal C.S. equal to one another.

To develop the signal representative of the current carried by the current sensing switch S₁, a current sensing circuit, generally depicted within the broken line block 120 of Fig. 7, is operatively connected with the Kelvin and the current sense terminals of current-sensing switch S₁ and to an appropriate potential associated with the power delivery circuit. Circuit 120 provides an output signal 125 to a comparator 127 for subsequent use in a known manner.

Specifically, the signal 125 appearing from sensing circuit 120 is a voltage level representative of the current in terminal C.S. of switch S₁, which is in turn proportional to the main current in switch S₁ and thus normally also through the load 14. A reference voltage, V_{REF}, is selected and connected to the "+" input of comparator 127 for comparison with the current-converted to-voltage signal 125 appearing at the "-" input of that comparator. The potential of V_{REF} is selected, in conjunction with circuit 120, to be representative of some threshold value of current in the current sense MOSFET circuit which is to be detected and indicated via the output of the comparator on line 129. Thus, so long as the voltage on line 125 is less than that of V_{REF}, the current in the current sense MOSFET, and normally through the H-bridge is presumed to be less than the monitored threshold value; whereas if the voltage on line 125 exceeds the V_{REF}, the comparator 127 provides an output 129 which indicates that the current in the H-bridge, or at least through current sensing MOSFET exceeds the monitored threshold value. It will be appreciated that signal 125 could be connected to an A-to-D converter or multiple comparators so as to monitor continuous or multiple current levels.

In order for the signal 125 from current sensing circuit 120 to be as representative as possible of the current in the H-bridge, or at least through the current sense MOSFET, it is necessary that its derivation be accomplished in a manner which is not adversely impacted by excursions in the power supply potential V_{BATT} and/or by temperature excursions in the circuitry and/or by load current excursions. In this regard, the current sensing circuitry 120 of the present invention is believed to be particularly well-suited. It should be noted that another current sensing circuit, also designated 120, is associated with the Kelvin terminal K and the current sense terminal C.S. of the current sensing MOSFET S₃ in the upper right arm of the H-bridge 110. It is of identical construction to the current sensing circuit 120 associated with current sensing MOSFET S₁.

Referring now to the current sensing circuit 120 depicted very generally in block form at the lower left in Fig. 7, there appear two serial branches BR₁ and BR₂, each of which includes at least two semiconductor devices, such as bipolar transistors or the like in which one is used in a transimpedance mode of operation. Serial branch BR₁ is connected at one end to the current sense terminal C.S. of current sensing switch S₁ and is connected at its other end to a reference potential in the power delivery circuit, in this instance, ground potential. Similarly, serial branch BR₂ is connected at one end to the Kelvin terminal K of current sensing switch S₁ and is connected at its other end to the same reference potential in the power delivery circuit, in this instance, ground potential.

In branch BR₁, there are two semiconductor devices Q₁ and Q₃ connected in serial circuit. Similarly, in branch BR₂ there are two other semiconductor devices, Q₂ and Q₄, connected in serial circuit therein. More particularly still, the semiconductor devices, which hereinafter for convenience will be referred to as transistors, are cross-connected to provide a particular bias control. Specifically, transistor Q₂ is cross-connected via lead CC₁₂ to transistor Q₁ operating in the transimpedance mode to provide bias control to the latter. Similarly, transistor Q₃ is cross-connected via lead CC₃₄ to transistor Q₄ operating in the transimpedance mode to provide bias control to the latter.

A sensing resistor R_{S} is shown in serial circuit with transistors Q₁ and Q₃ in branch BR₁ for developing the voltage signal 125 extended to comparator 127. Though the sensing resistor is shown in the generic circuit of Fig. 7 as being the only resistor depicted in the current sensing circuit 120 and further as being connected between transistor Q₃ and ground, it will be understood that other resistors might be included elsewhere in the branch circuits BR₁ and BR₂ and further, that the sensing resistor R_{S} might be connected between transistors Q₁ and Q₃ in branch circuit BR₁. It also will be understood that a capacitor can be included electrically in parallel with the sense resistor R_{S} which will bypass potential current spikes caused by turn-on and turn-off of the current sense MOSFET.

The described branch circuits BR₁ and BR₂ serve to provide, via transistors Q₁ and Q₂, an impedance-matching buffer, or pseudo or inverted current mirror, in the upper portion of the circuit 120 and connected to the terminals C.S. and K, whereas transistors Q₃ and Q₄ in the lower portion of circuit 20 define a more conventional current mirror. The bottom two transistors, Q₃ and Q₄, operate in current-mirror fashion to maintain near-equal collector currents, and therefore base-emitter voltages, through the upper transistors Q₁ and Q₂.

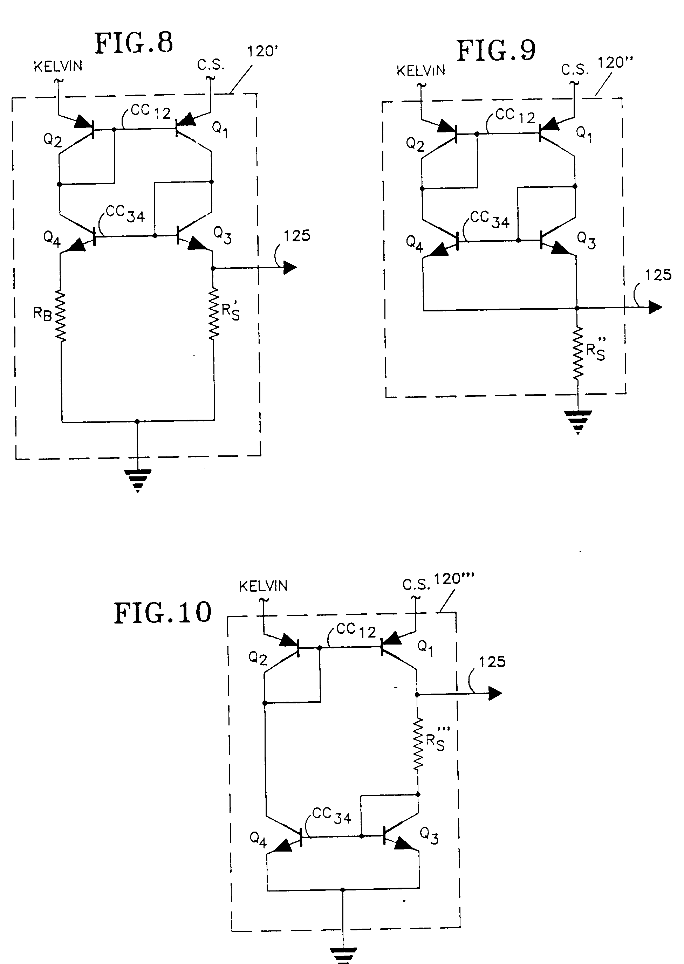

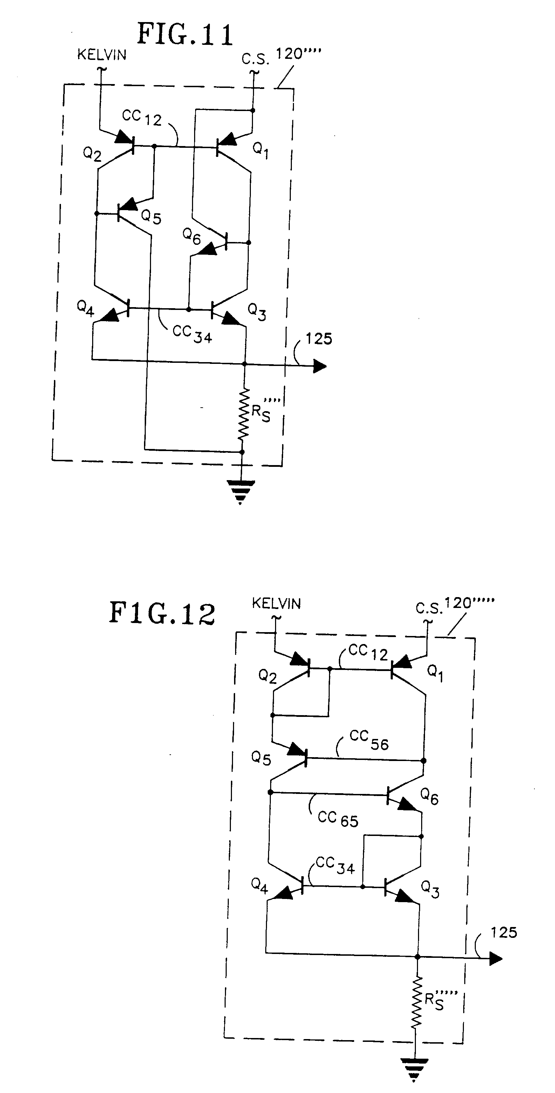

For a better understanding of the current sensing circuitry 120 depicted generally in Fig. 7, reference is made to several alternative, specific embodiments thereof as depicted in Figs. 8, 9, 10, 11, and 12, respectively. To emphasize any differences between those circuits, the current sensing circuit of Fig. 8 is designated 120′, that of Fig. 9 is designated 120˝, that of Fig. 10 is designated 120‴ that of Fig. 11 is designated 120˝˝, and that of Fig. 12 is designated 120˝‴. On the other hand, the transistors Q₁-Q₄ each bear the same identifying reference and will typically be the same from one circuit to the next, though some variation is contemplated within the scope of the invention. Additionally, Figs. 11 and 12 have transistors Q₅ and Q₆. In each instance, it is important that the betas (β) of transistors Q₁ and Q₂ be the same and the betas of transistors Q₃ and Q₄ be the same. Thus, transistors Q₁ and Q₂ are preferably two matched PNP transistors and transistors Q₃ and Q₄ are two matched NPN transistors. In some instances, it may also be desirable that the betas (β) of transistors Q₁ and Q₂ be the same as those of transistors Q₃ and Q₄. Higher values of beta result in more accurate current mirroring between Q₁ and Q₂ and between Q₃ and Q₄. The end result is that the base-emitter voltages of Q₁ and Q₂, and thus the voltages at the C.S. and Kelvin terminals, will become more equal. The transistors in these exemplary embodiments are incorporated in an integrated circuit.

The sense impedance or resistance across which the sense voltage is developed, has been designated R_{S}′ in Fig. 8, R_{S}˝ in Fig. 9, R_{S}‴ in Fig. 10, R_{S}˝˝ in Fig. 11 and R_{S}˝‴ in Fig. 12. While the function of sense resistor R_{S}′-R_{S}˝˝ is similar in each of those embodiments, its actual value and positioning within the circuit may vary somewhat. Accordingly, the superscripted primes have been applied for ease of identification. In each instance, the sense resistor R_{S}′-R_{S}˝‴ will appear in serial circuit with the transistors Q₁ and Q₃ in branch BR₁ and which is in turn connected to the current sense terminal C.S. of current sense switch S₁.

Referring to Fig. 8, the current sensing circuit 120′ includes transistors Q₁ and Q₃ connected in serial circuit between current sense terminal C.S. and ground. It further includes transistors Q₂ and Q₄ connected in serial circuit between the Kelvin terminal and ground. Transistor Q₂ is connected in a shorted base-to-collector configuration and has its base cross-connected to the base of transistor Q₁ via cross-connection CC₁₂. Transistor Q₂ effectively provides a bias signal for controlling transistor Q₁. Connected this way, transistor Q₂ acts like a diode, thereby regulating the base-to-emitter voltage of transistor Q₁ and thus controlling the base current of transistor Q₁. In this configuration, transistors Q₁ and Q₂ constitute an impedance matching buffer connected to the Kelvin terminal K and current sense terminal C.S. of the sensing switch S₁.

Transistor Q₃ is connected in a shorted base-to-collector configuration and its base is connected to the base of transistor Q₄ via cross-connection CC₃₄. The collector of transistor Q₃ is connected to collector of transistor Q₁ and the collector of transistor Q₄ is connected to the collector of transistor Q₂. Transistor Q₃ serves to provide a bias control signal to the transistor Q₄ via the cross-connection CC₃₄. Transistors Q₃ and Q₄ operate as a current mirror to maintain near-equal collector currents, and therefore base-emitter voltages, through transistors Q₁ and Q₂.

It can be appreciated that one can ratio the emitter areas of the transistors in BR₁, i.e. Q₁ and Q₃, versus the emitter areas of the transistors in BR₂, i.e. Q₂ and Q₄, to decrease the power dissipation in one leg of the current sensing circuit. The collector current in transistor Q₃ will not be equal but will be proportional to the collector current in transistor Q₄ by the same proportional difference in the emitter area of the two transistors. The same effect occurs for transistors Q₁ and Q₂. The end result is that the base-emitter voltages of Q₁ and Q₂ will be equal while the power dissipation in the current sensing circuit will be decreased.

A bias resistor R_{B} is connected in series circuit with the transistors Q₂ and Q₄, with one end connected to the emitter of transistor Q₄ and the other connected to ground potential. The inclusion of resistor R_{B} helps to minimize the power dissipation through transistor Q₄ which might otherwise become significant if high currents are being sensed and/or the transistors are contained in an integrated circuit. The sense resistor R_{S}′ is connected between the emitter of transistor Q₃ and ground in the first branch circuit. The sense voltage is provided at an output node appearing at the junction between the resistor R_{S}′ and the emitter of transistor Q₃. The sense voltage is thus the differential voltage appearing across the sense resistor R_{S}′. Changes in the "on-resistance" of the current sense MOSFETs have no significant affect on the stability of the sense current ratio. The sense resistor R_{S}′ is referenced to ground, which results in the sense voltage being independent of the actual potential of the supply voltage, V_{BATT}. It will be understood that the potential of V_{BATT}, which is nominally 12 volts, may be expected to vary between a potential as low as 6 volts and as high as 45 volts or more during transients. This circuit is also relatively insensitive to load current changes. For high-side drives or situations in which the current sensing circuitry is connected to a high-side switch, there is no requirement for the comparator to have a common-mode voltage near equal to the potential of the supply voltage V_{BATT}, and the voltage reference is independent of that supply voltage. Further, the sense voltage can be an order of magnitude or more larger than prior art circuits, such as in U.S. 4,654,568, such that amplification is not required.

An alternative to the current sensing circuitry of 120′ of Fig. 8 is depicted in the current sensing circuitry of 120˝ of Fig. 9. That circuit is structured similarly to that of Fig. 8 with respect to the arrangement of the four transistors Q₁-Q₄, however it omits the use of a separate biasing resistor R_{B} in the second branch. Instead, a sense resistor R_{S}˝ appears not only in serial circuit with transistors Q₁ and Q₃ of the first branch, but is also shared in serial circuit with transistors Q₂ and Q₄ of the second branch. The use of a single resistor R_{S}˝ provides at least two advantages over the circuitry of Fig. 8, the first being that one less input/output (I/O) pin is needed if it is assumed that the transistors are part of an integrated circuit and the resistances are external discrete devices. Secondly, there is no dependency on current ratio due to resistor matching between R_{S}′ and R_{B}. Of course the value of R_{S}˝ will have to be selected such that it provides the requisite sense voltage level for anticipated conditions. The tolerance of the resistor R_{S}˝ continues to affect the ability to sense accurately because that sensing is actually a voltage and not the current. However, it will be appreciated that very low tolerances in R_{S}˝ come at a very low cost penalty.

Referring now to the current sensing circuitry 120‴ in Fig. 10, there is depicted another alternative to the arrangements of Fig. 8 and Fig. 9. Relative to the current sensing circuits 120′ and 120˝ of Figs. 8 and 9 respectively, the inverted current mirror Q₁ and Q₂ and the current mirror Q₃ and Q₄ of circuit 120‴ functions in a substantially similar manner. On the other hand, circuitry 120‴ employs a single sense resistor R_{S}‴ located in the first branch in serial connection between the collector of Q₁ and the collector of Q₃. No separate resistor is contained in the second branch with transistors Q₂ and Q₄. Although reliance upon a single resistor RS‴ in current sensing circuit 120‴ may serve to reduce the count of resistive elements employed, it may not reduce the number of I/O pins if the transistors are part of an integrated circuit since one end of resistor R_{S}‴ would have to be connected to transistor Q₃ and the other end would have to be connected to the collector of transistor Q₁. Moreover, the omission of a resistance in the serial branch having transistors Q₂ and Q₄ may result in a greater-than-desired power dissipation through transistor Q₄ in the event of high sense currents. Still further, the positioning of sense resistor R_{S}‴ between transistors Q₃ and Q₁ further introduces an offset voltage occasioned by the V_{BE} of transistor Q₃. For that latter reason, it may be more desirable to sense the differential voltage across the sense resistor, which is more conveniently done in the embodiments of Fig. 8 and Fig. 9.

In Fig. 11 there is depicted a further refinement of the invention, in which the current sensing circuit 120˝˝ includes, in addition to the transistors Q₁ through Q₄ described above, fifth and sixth transistors Q₅ and Q₆ respectively. The base of PNP transistor Q₅ is connected to the collectors of transistors Q₂ and Q₄. The emitter of transistor Q₅ is connected to the common-base connection CC₁₂ of transistors Q₁ and Q₂, and the collector of transistor Q₅ is connected to the reference potential. Transistor Q₅ replaces the shorted base-to-collector connection of transistor Q₂. Likewise, the base of NPN transistor Q₆ is connected to the collectors of transistors Q₁ and Q₃. The emitter of transistor Q₆ is connected to the common-base connection of transistors Q₃ and Q₄, and the collector of transistor Q₆ is connected to the emitter of transistor Q₁. Transistor Q₆ replaces the shorted base-to-collector connection of transistor Q₃. The addition of transistors Q₅ and Q₆ in this manner results in current sensing circuit 120˝˝ being less sensitive to beta variations, and thus temperature, in transistors Q₁ through Q₄. As in the embodiment of Fig. 9, a sense resistor R_{S}˝˝ is connected at one end to the reference potential and at the other end to transistor Q₃ of branch 1 and to transistor Q₄ of branch 2. The sense voltage signal 25 appears at the node between resistor R_{S}˝˝ and the emitters of transistors Q₃ and Q₄.

In Fig. 12 there is depicted yet a further embodiment of the invention in which the current sensing circuit 120˝‴ includes fifth and sixth transistors Q₅ and Q₆ respectively, connected in an alternate configuration from that of Fig. 11. Transistors Q₁ and Q₂ and transistors Q₃ and Q₄ are cross-connected at their respective bases by CC₁₂ and CC₃₄ respectively as in the embodiment of Fig. 9. Similarly, the collectors of transistors Q₂ and Q₃ are shorted to their respective bases. Similarly also, the sense resistor R_{S}˝‴ is not only in serial circuit with transistors Q₁ and Q₃ of the first branch, but is also shared in serial circuit with transistors Q₂ and Q₄ of the second branch. The sense voltage 125 is obtained at the junction node between resistor R_{S}˝‴ and the emitters of transistors Q₃ and Q₄. However, transistors Q₅ and Q₆ are serially connected in the second and the first branches respectively.

More particularly in Fig. 12, transistor Q₅ is of the PNP type and has its emitter connected to the collector of transistor Q₂ and its collector connected to the collector of transistor Q₄. Transistor Q₆ is of the NPN type and has its emitter connected to the collector of transistor Q₃ and its collector connected to the collector of transistor Q₁. The base of transistor Q₅ is connected across to the collector of transistor Q₆ in the first branch by cross-connection CC₅₆. The base of transistor Q₆ is connected across to the collector of transistor Q₅ in the second branch via cross-connection CC₆₅.

Owing to the so-called Early voltage effect, changes in the voltage across a transistor may cause a change in its beta (β). Thus, for changes in the supply voltage V_{BATT}, the voltages across the transistors operating in the transimpedance mode, i.e., Q₁ and Q₄, will change and will affect their betas (β) relative to the betas (β) of their respective mirroring transistors Q₂ and Q₃ and thus cause variations in the ratios. However, the addition of transistors Q₅ and Q₆, connected as shown in Fig. 12, serves to drop most of the voltage across those two transistors, thereby minimizing voltage changes across transistors Q₁ and Q₄ and thus minimizing the undesirable Early voltage effects. This results in improved performance over the range of possible variation in the supply voltage since the voltage across transistors Q₃ and Q₄ differ by only a diode drop, regardless of supply voltage. However, circuit 120˝‴ does exhibit a slightly larger voltage drop across the active elements of each branch than do the other embodiments, which results in somewhat of a decrease in operating voltage range for a given sense current.

It should be understood that the invention is not limited to the particular embodiments shown and described herein, but that various changes and modifications may be made without departing from the scope of this novel concept as defined by the following claims. By way of example, the current sensing MOSFETs might be used as linear control devices rather than as switches; the major and minor current-carrying cellular portions of the current sensing devices might be simply a relatively large cell of greater current-carrying capacity and a smaller cell of much less capacity; the output signal 125 might be utilized or monitored in a linear manner rather than with respect only to a threshold; and the current sensing circuitry might be either in fully integrated circuit form, or it may be all or partly comprised of discrete components.

## Claims

1. A current detection circuit in combination with a current controlling MOSFET device (S₁) in a power delivery circuit for supplying load current to a load (14), the current controlling MOSFET device (S₁) being multicellular, with a major current-carrying cellular portion (C₃-Cₙ) and a minor current-carrying cellular portion, a first main current terminal (18) for connection to a source of power (V_{BATT}), a gate terminal for receiving a control signal, a second main current terminal (16) connecting the major current-carrying cellular portion (C₃-Cₙ),a first auxiliary terminal (40; C.S.) connected at one end to the minor current-carrying cellular portion (C₁, C₂) so as to provide a current generally proportional to the main device current, a second auxiliary terminal (42; K) connected at one end to the major current-carrying cellular portion, and an output node (52) for providing an output signal approximately proportional to the main device current, characterized in that the current detection circuit comprises:
a first branch (BR₁) connected between the first auxiliary terminal (40; C.S.) and a reference potential in the power delivery circuit and including a first series connected semiconductor device (44; Q₁) and an impedance means (48; RS),; the impedance means (48, RS) being connected in series circuit in the first branch (BR1) for producing a voltage approximately proportional to the main device current at said output node (52); at one end of said impedance means (48;RS);
a second branch (BR₂) connected between the second auxiliary terminal (42; K) and said reference potential in the power delivery circuit and including a second series connected semiconductor device (46; Q₂);
said first semiconductor device (44; Q₁) operating in a transimpedance mode coupling the current from the first auxiliary terminal (40; C.S.) to the impedance means (48; RS) and being controlled by a bias signal;
said second semiconductor device (46; Q₂) being cross-connected with said first semiconductor device (44; Q₁) to provide the respective said bias signal thereto; and
wherein said second semiconductor device (46; Q₂) is connected in said second branch (BR₂) in a manner providing said bias signal for controlling said first semiconductor device (44; Q₁) so as to result in said output signal at said output node (52) being proportional to the main device current within a relatively small tolerance range across a relatively broad operating range.

2. The combination of claim 1 characterized in that said second semiconductor device (46; Q₂) is interconnected to said first semiconductor device (44; Q₁) in a current mirror configuration so as to maintain said first (40; C.S.) and second (42; K₉) auxiliary terminals at substantially the same voltage.

3. The combination of claim 2 characterized in that said first and second semiconductor devices are first (44; Q₁) and second (46; Q₂) bipolar transistors respectively with commonly connected base electrodes and the base electrode of said second transistor (46; Q₂) interconnected to the collector electrode of said second transistor (46; Q₂) in a current mirror configuration.

4. The combination of claim 2 characterized in that said base electrode of said second transistor (46; Q₂) is shorted to the collector electrode of said second transistor (46; Q₂).

5. The combination of claim 3 or 4 characterized in that said first (44; Q₁) and second (46; Q₂) transistors are formed of matched silicon.

6. The combination of any of claims 1 to 5 characterized in that
said first branch (BR₁) includes a third semiconductor device (Q₃);
said second branch (BR₂) includes a fourth semiconductor device (Q₄); and
said third (Q₃) and fourth (Q₄) semiconductor devices being interconnected in a current mirror configuration.

7. The combination of claim 6 characterized in that
said first (Q₁) and third (Q₃) semiconductor devices are series-connected;
said second (Q₂) and fourth (Q₄) semiconductor devices are series-connected;
said first (Q₁) and said fourth (Q₄) semiconductor devices operating in a transimpedance mode and each being controlled by bias signals; and
said second (Q₂) and said third (Q₃) semiconductor devices being cross-connected with said first (Q₁) and said fourth (Q₄) semiconductor devices respectively to provide the respective said bias signals thereto.

8. The combination of claim 7 characterized in that said first (Q₁), second (Q₂), third (Q₃) and fourth (Q₄) semiconductor devices comprise first , second, third and fourth transistors respectively, said first (Q₁) and second (Q₂) transistors being one of two conductivity types and said third (Q₃) and said fourth (Q₄) transistors being the other of the two conductivity types.

9. The combination of any of claims 6 to 8 characterized in that said first (Q₁), second (Q₂), third (Q₃) and fourth (Q₄) transistors are each bipolar transistors.

10. The combination of any of claims 6 to 9 characterized in that the first main current terminal (18; D) of the current controlling device (S₁) is adapted to be connected to one polarity of said source of power (V_{BATT}) having relatively opposite polarities, the second main current terminal (16; S) of the current controlling device (S₁) is adapted to be connected to one side of said load (14) the other side of the load (14) being adapted to be connected to the other polarity of the source of power (V_{BATT}), and that both said first (Q₁) and said second (Q₂) transistors are PNP transistors and both said third (Q₃) and said fourth (Q₄) transistors are NPN transistors.

11. The combination of any of claims 6 to 10 characterized in that the betas (β) of said first (Q₁) and said second (Q₂) transistors are substantially identical and the betas (β) of said third (Q₃) and said fourth (Q₄) transistors are substantially identical.

12. The combination of claim 9 characterized in that said second (Q₂) and said third (Q₃) transistors are each connected in respective shorted base-to-collector configurations and wherein the base of said second transistor (Q₂) is connected to the base of said first transistor (Q₁) and the base of said third transistor (Q₃) is connected to the base of said fourth transistor (Q₄).

13. The combination of any of claims 1 to 12 characterized in that said impedance means comprises a first resistor (48; Rₛ) in said first branch (BR₁).

14. The combination of claim 13 characterized in that said second branch circuit (BR₂) includes a respective second resistor (50; R_{B}) in series circuit therewith.

15. The combination of claim 13 characterized in that said first resistor (Rₛ"; Rₛ"") further being connected in series circuit in said second branch (BR₂) whereby said first resistor (Rₛ"; R_{S}"") is connected in common in said first (BR₁) and second (BR₂) branches.

16. The combination of any of claims 1 to 15 characterized in that said one polarity of a source of power (V_{BATT}) is relatively more positive than said other polarity of the source of power (V_{BATT}) such that said current controlling device (S₁) is connected in the relatively more positive, or high, side of the power delivery circuit relative to the load (14).

17. The combination of any of claims 6 to 16 further characterized in that it includes fifth (Q₅) and sixth (Q₆) bipolar transistors, said fifth transistor (Q₅) being of the same conductivity type (PNP) as said first (Q₁) and second (Q₂) transistors and said sixth transistor (Q₆) being of the same conductivity type (NPN) as said third (Q₃) and fourth (Q₄) transistors, the emitter-base junction of said fifth transistor (Q₅) being connected between the base and collector of said second transistor (Q₂), the emitter-base junction of said sixth transistor (Q₆) being connected between the base and collector of said third transistor (Q₃), the collector of said fifth transistor (Q₅) being adapted to be connected to the reference potential and the collector of said sixth transistors (Q₆) being adapted to be connected to said first auxiliary terminal (C.S.) of said current controlling device, whereby to reduce sensitivity to the betas (β) of the first (Q₁), second (Q₂), third (Q₃) and fourth (Q₄) transistors.

18. The combination of any of claims 6 to 16 characterized in that it includes fifth (Q₅) and sixth (Q₆) bipolar transistors, said second (Q₂), and said third (Q₃) transistors each connected in respective shorted base-to-collector configurations, the fifth transistors (Q₅*)* having its emitter and collector connected in serial circuit in the second branch (BR₂) between said second (Q₂) and said fourth (Q₄) transistors, the sixth transistor (Q₆) having its emitter and collector connected in serial circuit in the first branch (BR₁) between said first (Q₁) and said third (Q₃) transistors, the bases of said fifth (Q₅) and said sixth (Q₆) transistors being connected to the collectors of said sixth (Q₆) and said fifth (Q₅) transistors respectively, whereby voltage drops between the emitters and collectors of the respective said fifth (Q₅) and sixth (Q₆) transistors serve to limit the voltage drops between the emitters and collectors of the respective said first (Q₁) and fourth (Q₄) transistors to thereby reduce variations in the betas (β) of the first (Q₁), second (Q₂) third (Q₃) and fourth (Q₄) transistors for variations in the voltage across the power delivery circuit.

19. The combination of any of claims 1 to 18 further characterized by further comprising current turn-off means (26) for turning off the current controlling device (S₁) via the gate terminal (G₁) when the current detection circuit (24) detects load current in excess of a predetermined level.

## Patentansprüche

1. Stromerfassungsschaltung in Kombination mit einem Stromsteuerungs-MOSFET-Bauelement (S₁) in einer Leistungszuführschaltung zum Einspeisen eines Laststroms in eine Last (14), wobei das Stromsteuerungs-MOSFET-Bauelement (S₁) mehrzellig ist und einen zellularen Haupt-Stromführabschnitt (C₃Cₙ) und einen zellularen Neben-Stromführabschnitt aufweist, ferner einen ersten Haupt-Stromanschluß (18) für die Verbindung mit einer Leistungsquelle (V_{BATT}), einen Gateanschluß für den Empfang eines Steuersignals, einen zweiten Haupt-Stromanschluß (16) zum Verbinden mit dem zellularen Haupt-Stromführabschnitt (C₃-Cₙ), einen ersten Hilfsanschluß (40; C.S.), der mit einem Ende an den zellularen Neben-Stromführabschnitt (C₁, C₂) angeschlossen ist, um einen Strom zu liefern, der etwa proportional zu dem Haupt-Bauelementstrom ist, einen zweiten Hilfsanschluß (40; K) der mit einem Ende an den zellularen Haupt-Stromführabschnitt angeschlossen ist, und einen Ausgangsknoten (52) zum Bereitstellen eines Ausgangssignals, welches annähernd proportional zu dem Haupt-Bauelementstrom ist, **dadurch gekennzeichnet**, daß die Stromerfassungsschaltung aufweist:
einen ersten Zweig (BR₁), der zwischen den ersten Hilfsanschluß (40; C.S.) und ein Referenzpotential in der Leistungszuführschaltung gelegt ist und eine erste Reihenschaltung aus einem Halbleiterbauelement (44; Q₁) und einer Impedanzeinrichtung (48; RS) aufweist, von der die Impedanzeinrichtung (48; RS) in Reihenschaltung in dem ersten Zweig (BR₁) liegt, um eine Spannung zu erzeugen, die annähernd proportional zu dem Haupt-Bauelementstrom an dem Ausgangsknoten (52) an einem Ende der Impedanzeinrichtung (48; RS) ist;
einen zweiten Zweig (BR₂), der zwischen dem zweiten Hilfsanschluß (42) und dem Referenzpotential in der Leistungszuführschaltung liegt und ein zweites in Reihe geschaltetes Halbleiterbauelement (46; Q₂) aufweist;
wobei das erste Halbleiterbauelement (44; Q₁) in einer Tmnsimpedanzbetriebsart arbeitet, bei der der Strom von dem ersten Hilfsanschluß (40; C.S.) zu der Impedanzeinrichtung (48; RS) gekoppelt und von einem Vorspannungssignal gesteuert wird;
das zweite Halbleiterbauelement (46; Q₂) mit dem ersten Halbleiterbauelement (44; Q₁) derart über Kreuz verbunden ist, daß ihm das betreffende Vorspannungssignal zugeführt wird; und
wobei das zweite Halbleiterbauelement (46; Q₂) in dem zweiten Zweig (BR₂) in der Weise verschaltet ist, daß das Vorspannungssignal zum Steuern des ersten Halbleiterbauelements (44; Q₁) so geliefert wird, daß sich am Ausgangsknoten (52) ein Ausgangssignal ergibt, welches in einem relativ breiten Betriebsbereich mit relativ geringer Toleranz proportional zu dein Haupt-Bauelementstrom ist.

2. Kombination nach Anspruch 1,
**dadurch gekennzeichnet**, daß das zweite Halbleiterbauelement (46; Q₂) mit dem ersten Halbleiterbauelement (44; Q₁) als Stromspiegel verschaltet ist, um den ersten (40; C.S.) und zweiten (42; K₉) Hilfsanschluß auf im wesentlichen der gleichen Spannung zu halten.

3. Kombination nach Anspruch 2,
**dadurch gekennzeichnet**, daß das erste und das zweite Halbleiterbauelement ein erster (44; Q₁) und ein zweiter (46; Q₂) Bipolartransistor sind, die in ihren Basiselektroden zusammengeschaltet sind, und bei denen die Basiselektrode des zweiten Transistors (46; Q₂) mit der Kollektorelektrode des zweiten Transistors (46; Q₂) nach Art eines Stromspiegels verbunden ist.

4. Kombination nach Anspruch 2,
**dadurch gekennzeichnet**, daß die Basiselektrode des zweiten Transistors (46; Q₂) mit der Kollektorelektrode des zweiten Transistors (46; Q₂) kurzgeschlossen ist.

5. Kombination nach Anspruch 2 oder 3,
**dadurch gekennzeichnet**, daß der erste (44; Q₁) und der zweite (46; Q₂) Transistor aus angepaßtem Silizium gefertigt sind.

6. Kombination nach einem der Ansprüche 1 bis 5,
**dadurch gekennzeichnet**, daß der erste Zweig (BR₁) ein drittes Halbleiterbauelement (Q₃) enthält,
der zweite Zweig (BR₂) ein viertes Halbleiterbauelement (Q₄) enthält; und
das dritte (Q₃) und das vierte (Q₄) Halbleiterbauelement als Stromspiegel miteinander verschaltet sind.

7. Kombination nach Anspruch 6,
**dadurch gekennzeichnet**, daß
das erste (Q₁) und das dritte (Q₃) Halbleiterbauelement in Reihe geschaltet sind;
das zweite (Q₂) und das vierte (Q₄) Halbleiterbauelement in Reihe geschaltet sind;
das erste (Q₁) und das vierte (Q₄) Halbleiterbauelement in einer Transimpedanzbetriebsart arbeiten und jeweils von Vorspannungssignalen gesteuert werden; und
das zweite (Q₂) und das dritte (Q₃) Halbleiterbauelement mit dem ersten (Q₁) und dem vierten (Q₄) Halbleiterbauelement über Kreuz verbunden sind, um ihnen die Vorspannungssignale zuzuführen.

8. Kombination nach Anspruch 7,
**dadurch gekennzeichnet**, daß das erste (Q₁), das zweite (Q₂), das dritte (Q₃) und das vierte (Q₄) Halbleiterbauelement einen ersten, einen zweiten, einen dritten bzw. einen vierten Transistor aufweisen, von denen der erste (Q₁) und der zweite (Q₂) Transistor einem von zwei Leitungstypen entsprechen, während der dritte (Q₃) und der vierte (Q₄) Transistor dem anderen der beiden Leitungstypen entsprechen.

9. Kombination nach einem der Ansprüche 6 bis 8,
**dadurch gekennzeichnet**, daß der erste (Q₁), der zweite (Q₂), der dritte (Q₃) und der vierte (Q₄) Transistor jeweils Bipolartransistoren sind.

10. Kombination nach einem der Ansprüche 6 bis 9,
**dadurch gekennzeichnet**, daß der erste Haupt-Stromanschluß (18; D) des Stromsteuerungsbauelements (S₁) dazu ausgebildet ist, an einen Pol der Leistungsquelle (V_{BATT}), die zueinander entgegengesetzte Polaritäten besitzt, angeschlossen zu werden, während der zweite Haupt-Stromanschluß (16; S) des Stromsteuerungsbauelements (S₁) dazu ausgebildet ist, an eine Seite der Last (14) angeschlossen zu werden, deren andere Seite dazu ausgebildet ist, an den anderen Pol der Leistungsquelle (V_{BATT}) angeschlossen zu werden, und daß sowohl der erste (Q₁) als auch der zweite (Q₂) Transistor PNP-Transistoren sind und sowohl der dritte (Q₃) als auch der vierte (Q₄) Transistor NPN-Transistoren sind.

11. Kombination nach einem der Ansprüche 6 bis 10,
**dadurch gekennzeichnet**, daß die Betas (β) des ersten (Q₁) und des zweiten (Q₂) Transistors im wesentlichen identisch sind, und die Betas (β) des dritten (Q₃) und des vierten (Q₄) Transistors im wesentlichen identisch sind.

12. Kombination nach Anspruch 9,
**dadurch gekennzeichnet**, daß der zweite (Q₂) und der dritte (Q₃) Transistor jeweils mit ihrer Basis und ihrem Kollektor kurzgeschlossen sind, wobei die Basis des zweiten Transistors (Q₂) an die Basis des ersten Transistors (Q₁) angeschlossen und die Basis des dritten Transistors (Q₃) an die Basis des vierten Transistors (Q₄) angeschlossen ist.

13. Kombination nach einem der Ansprüche 1 bis 12,
**dadurch gekennzeichnet**, daß die Impedanzeinrichtung einen ersten Widerstand (48; R₅) in dem ersten Zweig (BR₁) aufweist.

14. Kombination nach Anspruch 13,
**dadurch gekennzeichnet**, daß der zweite Schaltungszweig (BR₂) einen zugehörigen zweiten Widerstand (50; R_{B}) enthält, der mit ihm in Reihe geschaltet ist.

15. Kombination nach Anspruch 13,
**dadurch gekennzeichnet**, daß der erste Widerstand (R_{S}"; R_{S}"") außerdem in einer Reihenschaltung in dem zweiten Zweig (BR₂) liegt, wobei der erste Widerstand (R_{S}"; R_{S}"") mit dem ersten (BR₁) und dem zweiten (BR₂) Zweig gemeinsam geschaltet ist.

16. Kombination nach einem der Ansprüche 1 bis 15,
**dadurch gekennzeichnet**, daß der eine Pol der Leistungsquelle (V_{BATT}) relativ positiv ist gegenüber dem anderen Pol der Leistungsquelle (V_{BATT}), derart, daß das Stromsteuerungsbauelement (S₁) relativ zu der Last (14) an die relativ positive oder hohe Seite der Leistungszuführschaltung angeschlossen ist.

17. Kombination nach einem der Ansprüche 6 bis 16,
**dadurch gekennzeichnet**, daß sie einen fünften (Q₅) und einen sechsten (Q₆) Bipolartransistor enthält, von denen der fünfte Transistor (Q₅) vom gleichen Leitungstyp (PNP) wie der erste (Q₁) und der zweite (Q₂) Transistor ist, während der sechste Transistor (Q₆) vom gleichen Leitungstyp (NPN) wie der dritte (Q₃) und der vierte (Q₄) Transistor ist, wobei der Basis-Emitter-Übergang des fünften Transistors (Q₅) zwischen Basis und Kollektor des zweiten Transistors (Q₂) geschaltet ist, der Basis-Emitter-Übergang des sechsten Transistors (Q₆) zwischen Basis und Kollektor des dritten Transistors (Q₃) geschaltet ist, der Kollektor des fünften Transistors (Q₅) derart ausgebildet ist, daß er an das Referenzpotential gelegt wird, und der Kollektor des sechsten Transistors (Q₆) dazu ausgebildet ist, an den ersten Hilfsanschluß (C.S.) des Stromsteuerungsbauelements angeschlossen zu werden, wodurch die Empfindlichkeit bezüglich der Betas (β) des ersten (Q₁), des zweiten (Q₂), des dritten (Q₃) und des Vierten (Q₄) Transistors verringert wird.

18. Kombination nach einem der Ansprüche 6 bis 16,
**dadurch gekennzeichnet**, daß sie einen fünften (Q₅) und einen sechsten (Q₆) Bipolartransistor aufweist, wobei der zweite (Q₂) und der dritte (Q₃) Transistor jeweils mit Basis und Kollektor kurzgeschlossen sind, der fünfte Transistor (Q₅) mit seinem Emitter und Kollektor in Reihenschaltung im zweiten Zweig (BR₂) zwischen dem zweiten (Q₂) und dem vierten (Q₄) Transistor liegt, der sechste Transistor (Q₆) mit seiner Emitter-Kollektor-Strecke als Reihenschaltung in dem ersten Zweig (BR₁) zwischen dem ersten (Q₁) und dem dritten (Q₃) Transistor liegt, die Basen des fünften (Q₅) und des sechsten (Q₆) Transistors mit den Kollektoren des sechsen (Q₆) und des fünften (Q₅) Transistors verbunden sind, wodurch Spannungsabfälle zwischen den Emittern und Kollektoren des fünften (Q₅) und des sechsten (Q₆) Transistors dazu dienen, Spannungsabfälle zwischen den Emittern und Kollektoren des ersten (Q₁) und des vierten (Q₄) Transistors zu begrenzen um dadurch Schwankungen der Betas (β) des ersten (Q₁), des zweiten (Q₂), des dritten (Q₃) und des vierten (Q₄) Transistors bei Schwankungen der Spannung der Leistungszuführschaltung zu reduzieren.

19. Kombination nach einem der Ansprüche 1 bis 18,
**gekennzeichnet durch** eine Stromausschalteinrichtung (26) zum Ausschalten des Stromsteuerungsbauelements (S₁) über den Gateanschluß (G₁), wenn die Stromerfassungsschaltung (24) einen Laststrom erfaßt, der über einer vorbestimmten Stärke liegt.

## Revendications

1. Circuit de détection de courant en combinaison avec un dispositif de commande du courant à transistor MOSFET (S₁), dans un circuit d'alimentation de puissance pour fournir un courant de charge à une charge (14), le dispositif de commande du courant à transistor MOSFET (S₁) étant multicellulaire, avec une partie cellulaire principale porteuse de courant (C₃ à Cₙ) et une partie cellulaire secondaire porteuse de courant, une première borne de courant principal (18) destinée à être connectée à une source de puissance (V_{BATT}), une borne de grille pour recevoir un signal de commande, une deuxième borne de courant principal (16) connectant la partie cellulaire principale porteuse de courant (C₃ à Cₙ), une première borne auxiliaire (40; C.S.) connectée par une extrémité à la partie cellulaire secondaire porteuse de courant (C₁, C₂) de manière à fournir un courant globalement proportionnel au courant du dispositif principal, une deuxième borne auxiliaire (42; 40) connectée, par une extrémité, à la partie cellulaire principale porteuse de courant, et un noeud de sortie (52) pour fournir un signal de sortie à peu près proportionnel au courant du dispositif principal, caractérisé en ce que le circuit de détection de courant comprend :
une première ramification (BR₁) connectée entre la première borne auxiliaire (40; C.S.) et un potentiel de référence dans le circuit d'alimentation en puissance et comprenant un premier dispositif à semi-conducteur (44; Q₁) connecté en série et un moyen d'impédance (48; RS), le moyen d'impédance (48, RS) étant connecté dans un circuit série dans la première ramification (BR₁), pour produire une tension à peu près proportionnelle au courant du dispositif principal au niveau dudit noeud de sortie (52), à une extrémité dudit moyen d'impédance (48; RS),
une deuxième ramification (BR) connectée entre la deuxième borne auxiliaire (42; K) et ledit potentiel de référence dans le circuit d'alimentation en puissance et comprenant un deuxième dispositif à semi-conducteur (46; Q₂) connecté en série;
ledit premier dispositif à semi-conducteur (44; Q₁) fonctionnant dans un mode d'impédance couplant le courant provenant de la première borne auxiliaire (40; C.S) au moyen d'impédance (48; RS) et étant commandé par un signal de polarisation;
ledit deuxième dispositif à semi-conducteur (46; Q₂) étant interconnecté audit premier dispositif à semi-conducteur (44; Q₁) pour lui fournir ledit signal de polarisation respectif; et
dans lequel ledit dispositif à semi-conducteur (46; Q₂) est connecté dans ladite deuxième ramification (BR₂), de manière à fournir ledit signal de polarisation pour commander ledit premier dispositif à semi-conducteur (44; Q₁), de manière à donner lieu, au niveau dudit noeud de sortie (52), audit signal de sortie proportionnel au courant de dispositif principal, dans une plage de tolérance relativement petite sur une plage de fonctionnement relativement large.

2. Combinaison selon la revendication 1, caractérisée en ce que ledit deuxième dispositif à semi-conducteur (46; Q₂) est interconnecté avec ledit premier dispositif à semi-conducteur (44; Q₁), dans une configuration symétrique de courant, de manière à maintenir lesdites première (40; C.S.) et deuxième (42; K9) bornes auxiliaires sensiblement à la même tension.

3. Combinaison selon la revendication 2, caractérisée en ce que lesdits premier et deuxième dispositifs à semi-conducteurs sont des premier (44; Q₁) et deuxième (46; Q₂) transistors bipolaires a base commune et la base dudit deuxième transistor (46; Q₂) interconnectée avec le collecteur dudit deuxième transistor (46; Q₂), dans une configuration symétrique de courant.

4. Combinaison selon la revendication 2, caractérisée en ce que ladite base dudit deuxième transistor (46; Q₂) est court-circuitée par rapport au collecteur dudit deuxième transistor (46; Q₂).

5. Combinaison selon la revendication 2 ou 4, caractérisée en ce que lesdits premier (44; Q₁) et deuxième (46; Q₂) transistors sont constitués de silicium adapté.

6. Combinaison selon l'une quelconque des revendications 1 à 5, caractérisée en ce que ladite première ramification (BR₁) comprend un troisième dispositif à semi-conducteur (Q₃);
ladite deuxième ramification (BR₁) comprend un quatrième dispositif à semi-conducteur (Q₄); et
lesdits troisième (Q₃) et quatrième (Q₄) dispositifs à semi-conducteurs étant interconnectés dans une configuration symétrique de courant.

7. Combinaison selon la revendication 6, caractérisée en ce que
lesdits premier (Q₁) et troisième (Q₃) dispositifs à semi-conducteurs sont connectés en série;
lesdits deuxième (Q₂) et quatrième (Q₄) dispositifs à semi-conducteurs sont connectés en série;
lesdits premier (Q1) et quatrième (Q4) dispositifs à semi-conducteurs fonctionnant dans un mode d'accord d'impédance, et chacun étant commandé par des signaux de polarisation; et
lesdits deuxième (Q₂) et troisième (Q₃) dispositifs à semi-conducteurs étant interconnectés avec lesdits premier (Q₁) et quatrième (Q₄) dispositifs à semi-conducteurs, respectivement, pour leur fournir lesdits signaux de polarisation respectifs.

8. Combinaison selon la revendication 7, caractérisée en ce que lesdits premier (Q₁), deuxième (Q₂), troisième (Q₃) et quatrième (Q₄) dispositifs à semi-conducteurs comprennent respectivement des premier, deuxième, troisième et quatrième transistors, lesdits premier (Q₁) et deuxième (Q₂) transistors ayant l'un des deux types de conductivité et ledit troisième (Q₃) et quatrième (Q₄) transistors étant de l'autre des deux types de conductivité.

9. Combinaison selon l'une quelconque des revendications 6 à 8, caractérisée en ce que lesdits premier (Q₁), deuxième (Q₂), troisième (Q₃) et quatrième (Q₄) transistors sont chacun des transistors bipolaires.

10. Combinaison selon l'une quelconque des revendications 6 à 9, caractérisée en ce que la première borne de courant principal (18; D) du dispositif de commande de courant (S₁) est adaptée pour être connectée à une borne de ladite source d'alimentation (V_{BATT}) ayant des bornes de polarité relativement opposée, la deuxième borne de courant principal (16; S) du dispositif de commande de courant (S₁) est adaptée pour être connectée à un côté de ladite charge (14), l'autre côté de la charge (14) étant adaptée pour être connectée à l'autre polarité de la source d'alimentation (V_{BATT}), et en ce que, à la fois, lesdits premier (Q₁) et deuxième (Q₂) transistors sont des transistors PNP et à la fois lesdits troisième (Q₃) et quatrième (Q₄) transistors sont des transistors NPN.

11. Combinaison selon l'une quelconque des revendications 6 à 10, caractérisée en ce que les (β) desdits premier (Q₁) et deuxième (Q₂) transistors sont sensiblement identiques et les (β) desdits troisième (Q₃) et quatrième (Q₄) sont sensiblement identiques.

12. Combinaison selon la revendication 9, caractérisée en ce que lesdits deuxième (Q₂) et troisième (Q₃) transistors sont chacun connectés dans des configurations court-circuitées, respectives, base/collecteur et dans laquelle la base dudit deuxième transistor (Q₂) est connectée à la base dudit premier transistor (Q₁) et la base dudit troisième transistor (Q₃) est connectée à la base dudit quatrième transistor (Q₄).

13. Combinaison selon l'une quelconque des revendications 1 à 12, caractérisée en ce que ledit moyen d'impédance comprend une première résistance (48; R₅) dans ladite première ramification (BR₁).

14. Combinaison selon la revendication 13, caractérisée en ce que ledit deuxième circuit de ramification (BR₂) comprend une deuxième résistance (50; R_{B}) respective dans un circuit série avec ce dernier.

15. Combinaison selon la revendication 13, caractérisée en ce que ladite première résistance (Rₛ", Rₛ"") est en outre montée dans un circuit série dans ladite deuxième ramification (BR₂), de manière que ladite première résistance (Rₛ", Rₛ"") est connectée en commun dans lesdites première (BR₁) et deuxième (BR₂) ramifications.

16. Combinaison selon l'une quelconque des revendications 1 à 15, caractérisée en ce que ladite première polarité d'une source d'alimentation (V_{BATT}) est relativement plus positive que ladite autre polarité de la source d'alimentation (V_{BATT}), de manière que ledit dispositif de commande de courant (S1) soit connecté au côté relativement plus positif ou plus élevé, du circuit d'amenée de puissance par rapport à la charge (14).

17. Combinaison selon l'une quelconque des revendications 6 à 16, caractérisée en outre en ce qu'elle comprend des cinquième (Q₅) et sixième (Q₆) transistors bipolaires, ledit cinquième transistor (Q₅) étant du même type de conductivité PNP que lesdits premier (Q₁) et deuxième (Q₂) transistors et ledit sixième transistor (Q₆) étant du même type de conductivité NPN que lesdits troisième (Q₃) et quatrième (Q₄) transistors, la jonction émetteur-base dudit cinquième transistor (Q₅) étant connectée entre la base et le collecteur dudit deuxième transistor (Q₂), la jonction émetteur-base dudit sixième transistor (Q₆) étant connectée entre la base et le collecteur dudit troisième transistor (Q₃), le collecteur dudit cinquième transistor (Q₅) étant adapté pour être connecté au potentiel de référence et le collecteur dudit sixième transistor (Q₆) étant adapté pour être connecté à ladite première borne auxiliaire (C.S.) dudit dispositif de commande de courant, de manière à réduire la sensibilité aux (β) des premier (Q₁), deuxième (Q₂), troisième (Q₃) et quatrième (Q₄) transistors.

18. Combinaison selon l'une quelconque des revendications 6 à 16, caractérisée en qu'elle comprend des cinquième (Q₅) et sixième (Q₆) transistors bipolaires, lesdits deuxième (Q₂) et troisième (Q₃) transistors étant chacun connectés dans des configurations court-circuitées base-collecteur, respectives, le cinquième transistor (Q₅) ayant son émetteur et son collecteur connectés dans un circuit série dans la deuxième ramification (BR₂), entre lesdits deuxième (Q₂) et quatrième (Q₄) transistors, le sixième transistor (Q₆) ayant son émetteur et son collecteur connectés dans un circuit série dans la première ramification (BR₁) entre lesdits premier (Q₁) et troisième (Q₃) transistors, les bases desdits cinquième (Q₅) et sixième (Q₆) transistors étant connectées aux collecteurs desdits sixième (Q₆) et cinquième (Q₅) transistors, respectivement, de manière que des chutes de tension, entre les émetteurs et les collecteurs desdits cinquième (Q₅) et sixième (Q₆) transistors respectifs, servent à limiter des chutes de tension entre les émetteurs et les collecteurs desdits premier (Q₁) et quatrième (Q₄) transistors respectifs, de manière à réduire les variations des (β) des premier (Q₁), deuxième (Q₂), troisième (Q3) et quatrième (Q4) transistors, pour des variations de la tension sur le circuit d'alimentation en puissance.

19. Combinaison selon l'une quelconque des revendications 1 à 18, caractérisée en outre par le fait qu'il comprend de plus un moyen d'interruption de courant (26) pour interrompre le dispositif de commande de courant (S1) via la borne de grille (G1), lorsque le circuit de détection de courant (24) détecte un courant de charge dépassant un niveau prédéterminé.
